# EUROPEAN PATENT APPLICATION

(11) **EP 4 203 636 A1**
(43) Date of publication of application: **28.06.2023**
(21) Application number: 21895176.2
(22) Date of filing: 22.11.2021
(51) Int. Cl.: H05K 7/20, F28D 15/02

(54) **HEAT DIFFUSION STRUCTURE AND ELECTRONIC DEVICE COMPRISING SAME**

(30) Priority: 23.11.2020 KR 20200157858
(71) Applicant: Samsung Electronics Co., Ltd., Suwon-si, Gyeonggi-do 16677 (KR)
(72) Inventor: AHN, Joseph, Suwon-si Gyeonggi-do 16677 (KR); KOO, Kyungha, Suwon-si Gyeonggi-do 16677 (KR); MOON, Hongki, Suwon-si Gyeonggi-do 16677 (KR)
(74) Representative: HGF
(86) International application number: PCT/KR2021/017195
(87) International publication number: WO 2022/108409

(57) **Abstract**

An electronic device according to various embodiments of the present disclosure may comprise: a housing; a printed circuit board disposed within the housing; an electrical element disposed on the printed circuit board; and a dissimilar metal structure disposed adjacent to the electrical element. The dissimilar metal structure comprises: a first metal part formed of a first material; a second metal part formed of a second material different from the first material, at least a portion of which is jointed to the first metal part; a vapor passage disposed in a space surrounded by the first metal part and the second metal part; and a wick structure disposed in contact with at least a portion of the vapor passage in the space, wherein when viewed from the dissimilar metal structure, a welded portion (bead) of the second metal part formed on an interface between the first metal part and the second metal part may be formed to surround at least a portion of the first metal part.

## Description

### [Technical Field]

The disclosure relates to a heat diffusion structure including a dissimilar metal structure and an electronic device including the same.

### [Background Art]

In line with remarkable development of information/communication technologies and semiconductor technologies, various types of electronic devices have been increasingly widespread and available. In particular, recent electronic devices have been developed such that the same can be carried and used for communication.

Electronic devices may refer to devices configured to perform according to installed programs, such as home appliances, electronic wallets, portable multimedia players, mobile communication terminals, tablet PCs, image/sound devices, desktop/laptop computers, vehicle navigation systems. For example, such electronic devices may output stored information as sounds or images. In line with the increasing degree of integration of electronic devices and widespread use of super-fast large-capacity wireless communication, it has recently become possible to equip a single electronic device (for example, a mobile communication terminal) with various functions. For example, not only a communication function, but also an entertainment function (for example, gaming), a multimedia function (for example, music/moving image playback), a communication/security function (for example, mobile baking), a scheduling function, and an electronic wallet function can be integrated in a single electronic device. Such electronic devices are becoming compact such that users can conveniently carry the same.

A large amount of heat may occur inside a portable electronic device, and the heating density may increase, as portable electronic devices (for example, smartphones) have recently become compact and flat, together with increasing demands for high degree of integration and high performance (for example, application of the latest technology such as 5G). Accordingly, there is a need for various heat diffusion structures for efficiently discharging heat generated by heat sources inside electronic devices.

### [Detailed Description of the Invention]

### [Technical Problem]

If a heat diffusion structure made of a single material is used for an electronic device, copper alloy may be used as the single material, and the same may be manufactured to have a designed thickness (for example, about 0.4mm) or more. If the thickness of the heat diffusion structure is reduced to increase the performance and integration of the electronic device in line with recent technological development, the same may result in degraded heat transfer capacity, irregular temperature distribution, and operating fluid leakage, thereby failing to provide the necessary strength and surface flatness.

In addition, copper alloy used for a conventional heat diffusion structure is made by brazing or diffusion bonding, and laser welding used therefor requires a large amount of energy due to the high reflectivity of copper alloy and limits the process environment (for example, vacuum environment), and this may increase costs for equipment and maintenance.

Embodiments of the disclosure provide a heat diffusion structure having a dissimilar metal structure wherein dissimilar metals may be bonded to each other and used, thereby reducing the size (for example, thickness) of the heat diffusion structure and providing improved heat dissipation and strength.

Embodiments of the disclosure provide a heat dissipation structure wherein dissimilar metals may be bonded and used in a specific condition, thereby reducing costs for equipment and process environment.

### [Technical Solution]

An electronic device according to various example embodiments of the disclosure may include: a housing, a printed circuit board disposed in the housing, an electrical element disposed on the printed circuit board, and a dissimilar metal structure disposed adjacent to the electrical element. The dissimilar metal structure may include: a first metal portion comprising a first material, a second metal portion comprising a second material different from the first material, wherein at least a part of the second metal portion is bonded to the first metal portion, a vapor passage disposed in a space surrounded by the first metal portion and the second metal portion, and a wick disposed in contact with at least a part of the vapor passage in the space, and when viewed from above the dissimilar metal structure, a welded portion of the second metal portion, the welded portion being disposed at an interface between the first metal portion and the second metal portion, may be disposed to surround at least a part of the first metal portion.

An electronic device according to various example embodiments of the disclosure may include: a housing, a printed circuit board disposed in the housing, an electrical element disposed on the printed circuit board, and a dissimilar metal structure disposed adjacent to the electrical element. The dissimilar metal structure may include: a first metal portion comprising a first material, a second metal portion comprising a second material different from the first material, wherein at least a part of the second metal portion is bonded to the first metal portion, a vapor passage disposed in a space surrounded by the first metal portion and the second metal portion, and a wick disposed in contact with at least a part of the vapor passage in the space, wherein when an interface of the first metal portion and the second metal portion is viewed from the inside of the dissimilar metal structure, a welded portion of the second metal portion and the first metal portion may be disposed to face each other and to be in contact with each other.

A method for manufacturing a dissimilar metal structure of an electronic device according to various example embodiments of the disclosure may include: forming a first metal portion and a second metal portion into a butt joint structure, and emitting a laser adjacent to an interface between the first metal portion and the second metal portion, wherein a position irradiated by the laser for bonding of the first metal portion and the second metal portion includes an area spaced apart by a specified distance toward the second metal portion, with reference to the interface between the first metal portion and the second metal portion.

### [Advantageous Effects]

A heat diffusion structure of an electronic device according to various example embodiments of the disclosure may prevent and/or reduce structural distortion and defection through a process that can replace brazing or diffusion bonding.

A heat diffusion structure of an electronic device according to various example embodiments of the disclosure may have a reduced structure thickness by bonding dissimilar metals, and may provide excellent heat conductivity, processability, and improved strength/hardness.

A heat diffusion structure of an electronic device according to various example embodiments of the disclosure may have a reduced size (for example, thickness) of the heat diffusion structure by bonding and using dissimilar metals, and may provide improved heat dissipation and strength.

Advantageous effects obtainable in the disclosure are not limited to the above-mentioned advantageous effects, and other advantageous effects not mentioned herein will be clearly understood from the following description by those skilled in the art to which the disclosure pertains.

### [Brief Description of Drawings]

The above and other aspects, features and advantages of certain embodiments of the present disclosure will be more apparent from the following detailed description, taken in conjunction with the accompanying drawings, in which:
FIG. 1 is a block diagram of illustrating an example electronic device in a network environment according to various embodiments;
FIG. 2 is a front perspective view of an electronic device according to various embodiments;
FIG. 3 is a rear perspective view of an electronic device according to various embodiments;
FIG. 4 is an exploded perspective view of an electronic device according to various embodiments;
FIG. 5 is a cross-sectional view illustrating an example heat diffusion structure disposed in an electronic device and a structure around the heat diffusion structure according to one of various embodiments;
FIG. 6 is a cross-sectional view illustrating an example heat diffusion structure and function according to various embodiments;
FIG. 7 is a diagram illustrating an outer surface of a housing of a heat diffusion structure according to various;
FIG. 8 is a diagram illustrating an outer surface of a housing of a heat diffusion structure according to various embodiments;
FIG. 9 is a cross-sectional view illustrating an inside of a housing of a heat diffusion structure, according to various embodiments;
FIG. 10A is a cross-sectional view illustrating a heat diffusion structure made of a dissimilar metal and a position irradiated by a laser according to various embodiments;
FIG. 10B is a cross-sectional view illustrating a heat diffusion structure made of a dissimilar metal and a position irradiated by a laser according to various embodiments;
FIG. 10C is a cross-sectional view illustrating a heat diffusion structure made of a dissimilar metal and a position irradiated by a laser according to various embodiments;
FIGS. 11A, 11B, 11C, 11D, 11E and 11F are cross-sectional views illustrating a heat diffusion structure made of a dissimilar metal and a position irradiated by a laser according to various embodiments;
FIGS. 12A, 12B and 12C are cross-sectional views illustrating a heat diffusion structure made of a dissimilar metal and a position irradiated by a laser according to various embodiments;
FIGS. 13A and 13B are cross-sectional views illustrating a heat diffusion structure made of a dissimilar metal and a position irradiated by a laser according to various embodiments;
FIG. 14A is a cross-sectional view illustrating a heat diffusion structure made of a dissimilar metal and a position irradiated by a laser according to various embodiments.
FIG. 14B is a projection view of FIG. 14A when viewed from the top according to various embodiments; and
FIG. 15A is a cross-sectional view illustrating a heat diffusion structure made of a dissimilar metal and a position irradiated by a laser according to various embodiments.
FIG. 15B is a view of FIG. 15A when viewed from the top according to various embodiments.

### [Mode for Carrying out the Invention]

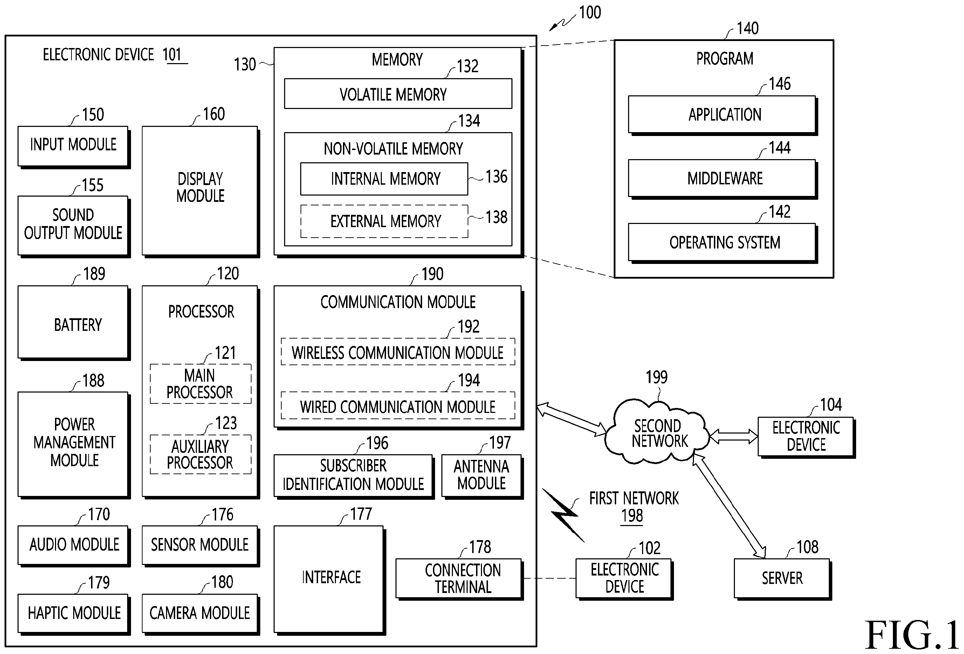

FIG. 1 is a block diagram illustrating an example electronic device 101 in a network environment 100 according to various embodiments.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In various embodiments, at least one of the components (e.g., the connecting terminal 178) may be omitted from the electronic device 101, or one or more other components may be added in the electronic device 101. In various embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active (e.g., executing an application) state. According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or an external electronic device (e.g., an electronic device 102 (e.g., a speaker or a headphone)) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, a home appliance, or the like. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), the element may be coupled with the other element directly (e.g., wiredly), wirelessly, or via a third element.

As used in connection with various embodiments of the disclosure, the term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the "non-transitory" storage medium is a tangible device, and may not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

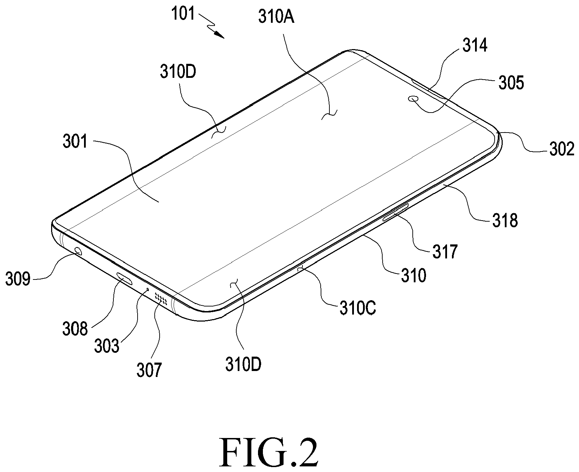

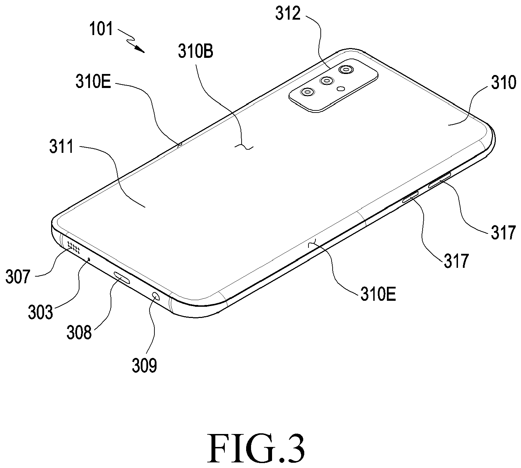

FIG. 2 is a front perspective view of an electronic device according to various embodiments. FIG. 3 is a rear perspective view of an electronic device according to various embodiments.

Referring to FIGS. 2 and 3, an electronic device 101 according to an embodiment may include a housing 310 including a front surface 310A, a rear surface 31 0B, and a side surface 310C surrounding the space between the front surface 310A and the rear surface 310B. In an embodiment (not illustrated), the housing 310 may refer to a structure which configures a part among the front surface 310A of FIG. 2 and the rear surface 310B and the side surface 310C of FIG. 3. According to an embodiment, at least a part of the front surface 310A may be configured by a substantially transparent front plate 302 (e.g., a glass plate or a polymer plate including various coating layers). The rear surface 310B may be configured by a rear plate 311. The rear plate 311 may be formed of, for example, glass, ceramic, a polymer, or a metal (e.g., aluminum, stainless steel (STS), or magnesium), or a combination of at least two of the above materials. The side surface 310C may be configured by a side bezel structure (or a "side member") 318 coupled to the front plate 302 and the rear plate 311 and including a metal and/or a polymer. In some embodiments, the rear plate 311 and the side bezel structure 318 may be integrally configured and may include the same material (e.g., glass, a metal material such as aluminum, or ceramic).

In the illustrated embodiment, the front plate 302 may include, at the long opposite side edges of the front plate 302, two first edge areas 310D which are bent and seamlessly extend from the front surface 310A toward the rear plate 311. In the illustrated embodiment (see FIG. 3), the rear plate 311 may include, at the long opposite side edges thereof, two second edge areas 310E which are bent and seamlessly extend from the rear surface 310B toward the front plate 302. In some embodiments, the front plate 302 (or the rear plate 311) may include only one of the first edge areas 310D (or the second edge areas 3 10E). In an embodiment, a part of the first edge areas 310D or the second edge areas 310E may not be included. In the above embodiments, when viewed from the side of the electronic device 101, the side bezel structure 318 may have a first thickness (or width) on the side where the first edge areas 310D or the second edge areas 310E are not included, and may have a second thickness, which is thinner than the first thickness, on the side where the first edge areas 310D or the second edge areas 310E are included.

According to an embodiment, the electronic device 101 may include at least one of a display 301, audio modules 303, 307, and 314 (e.g., the audio module 170 of FIG. 1), a sensor module (e.g., the sensor module 176 of FIG. 1), camera modules 305, 312, and 313 (e.g., the camera module 180 of FIG. 1), a key input device 317 (e.g., the input module 150 of FIG. 1), and connector holes 308 and 309 (e.g., the connection terminal 178 of FIG. 1) . In some embodiments, at least one (e.g., the connector hole 309) of the components may be omitted from the electronic device 101, or the electronic device 101 may additionally include other components.

According to an embodiment, the display 301 may be visually exposed through, for example, a substantial part of the front plate 302. In some embodiments, at least a part of the display 301 may be visible through the front plate 302 configuring the first edge areas 310D and the front surface 310A. In some embodiments, the edges of the display 301 may be configured to be substantially the same as the outer contour shape of the front plate 302 adjacent thereto. In an embodiment (not illustrated), the distance between the outer contour of the display 301 and the outer contour of the front plate 302 may be substantially constant in order to enlarge the visible area of the display 301.

According to an embodiment, the surface (or the front plate 302) of the housing 310 may include a screen display area formed as the display 301 is visually exposed. For example, the screen display area may include the front surface 310A and the first edge areas 310D.

In an embodiment (not illustrated), a recess or an opening may be disposed in a part of the screen display area (e.g., the front surface 310A and the first edge areas 310D) of the display 301, and at least one of the audio module 314, a sensor module (not illustrated), a light-emitting element (not illustrated), and the camera module 305 aligned with the recess or the opening may be included. In an embodiment (not illustrated), at least one of the audio module 314, the sensor module (not illustrated), the camera module 305, a fingerprint sensor (not illustrated), and the light-emitting element (not illustrated) may be included on the rear surface of the screen display area of the display 301. In an embodiment (not illustrated), the display 301 may be coupled to or disposed adjacent to a touch-sensing circuit, a pressure sensor capable of measuring the intensity (pressure) of a touch, and/or a digitizer which detects a magnetic field-type stylus pen. In some embodiments, at least a part of the key input device 317 may be disposed in the first edge areas 310D and/or the second edge areas 310E.

According to an embodiment, the audio modules 303, 307, and 314 may include, for example, a microphone hole 303 and speaker holes 307 and 314. The microphone hole 303 may include a microphone disposed therein so as to acquire external sound, and in some embodiments, a plurality of microphones may be disposed so as to detect the direction of sound. The speaker holes 307 and 314 may include an external speaker hole 307 and a phone call receiver hole 314. In some embodiments, the speaker holes 307 and 314 and the microphone hole 303 may be implemented as a single hole, or a speaker may be included without the speaker holes 307 and 314 (for example, a piezo speaker). The audio modules 303, 307, and 314 are not limited to the above structure, and various design changes may be made, such as mounting only some audio modules or adding a new audio module, depending on the structure of the electronic device 101.

According to an embodiment, the sensor module (not illustrated) may generate, for example, an electrical signal or data value corresponding to an internal operating state or an external environmental condition of the electronic device 101. The sensor module (not illustrated) may include, for example, a first sensor module (e.g., a proximity sensor) and/or a second sensor module (e.g., a fingerprint sensor) disposed on the front surface 310A of the housing 310, and/or a third sensor module (e.g., an HRM sensor) and/or a fourth sensor module (e.g., a fingerprint sensor) disposed on the rear surface 310B of the housing 310. In some embodiments (not illustrated), the fingerprint sensor may be disposed not only on the front surface 310A (e.g., the display 301) of the housing 310, but also on the rear surface 310B. The electronic device 101 may further include a sensor module which is not illustrated, for example, at least one of a gesture sensor, a gyro sensor, an air pressure sensor, a magnetic sensor, an acceleration sensor, a grip sensor, a color sensor, an infrared (IR) sensor, a biometric sensor, a temperature sensor, a humidity sensor, or an illuminance sensor. The sensor module is not limited to the above structure, and various design changes may be made, such as mounting only some sensor modules or adding a new sensor module, depending on the structure of the electronic device 101.

According to an embodiment, the camera modules 305, 312, and 313 may include, for example, a front camera module 305 disposed on the front surface 310A of the electronic device 101 and a rear camera device 312 disposed on the rear surface 310B, and/or a flash 313. The camera modules 305 and 312 may include one or more lenses, an image sensor, and/or an image signal processor. The flash 313 may include, for example, a light-emitting diode or a xenon lamp. In some embodiments, two or more lenses (an infrared camera lens, a wide-angle lens, and a telephoto lens) and image sensors may be arranged on one surface of the electronic device 101. The camera modules 305, 312, and 313 are not limited to the above structure, and various design changes may be made, such as mounting only some camera modules or adding a new camera module, depending on the structure of the electronic device 101.

According to an embodiment, the electronic device 101 may include a plurality of camera modules (e.g., a dual camera or a triple camera) each having different properties (e.g., angle of view) or functions. For example, multiple camera modules 305 and 312 including lenses having different angles of view may be configured, and the electronic device 101 may control, based on a user's selection, a change in the angle of view of the camera modules 305 and 312 performed by the electronic device 101. For example, at least one of the multiple camera modules 305 and 312 may be a wide-angle camera, and at least the other may be a telephoto camera. Similarly, at least one of the multiple camera modules 305 and 312 may be a front camera, and at least the other may be a rear camera. In addition, the multiple camera modules 305 and 312 may include at least one of a wide-angle camera, a telephoto camera, or an infrared (IR) camera (e.g., a time of flight (TOF) camera or a structured light camera). According to an embodiment, the IR camera may be operated as at least a part of a sensor module. For example, the TOF camera may be operated as at least a part of a sensor module (not illustrated) for detecting a distance to a subject.

According to an embodiment, the key input device 317 may be disposed on the side surface 310C of the housing 310. In an embodiment, the electronic device 101 may not include a part or all of the above-mentioned key input device 317, and the key input device 317, which is not included, may be implemented in another form such as a soft key on the display 301. In some embodiments, the key input device may include a sensor module 316 disposed on a rear surface310B of the housing 310.

According to an embodiment, the light-emitting element (not illustrated) may be disposed, for example, on the front surface 310A of the housing 310. The light-emitting element (not illustrated) may provide, for example, state information of the electronic device 101 in the form of light. In an embodiment, the light-emitting element (not illustrated) may provide a light source which is interlocked with, for example, an operation of the front camera module 305. The light-emitting element (not illustrated) may include, for example, an LED, an IR LED, and a xenon lamp.

According to an embodiment, the connector holes 308 and 309 may include, for example, a first connector hole 308 capable of receiving a connector (e.g., a USB connector) for transmitting or receiving power and/or data to or from an external electronic device, and/or a second connector hole (e.g., an earphone jack) 309 capable of receiving a connector for transmitting or receiving an audio signal to or from an external electronic device.

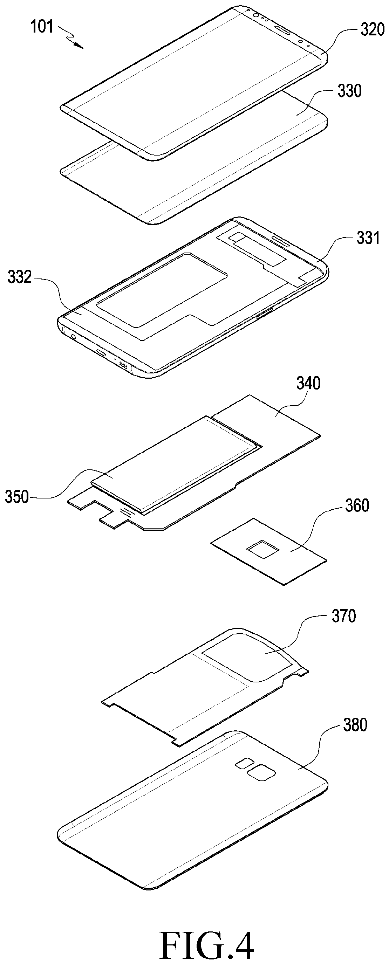

According to an embodiment, the camera module 305 of the camera modules 305 and 312 and/or some sensor modules among sensor modules (not illustrated) may be disposed to be exposed to the outside through at least a part of the display 301. For example, the camera module 305 may include a punch hole camera disposed inside a hole or a recess disposed on the rear surface of the display 301. According to an embodiment, the camera module 312 may be disposed inside the housing 310 such that a lens is exposed to the rear surface 310B of the electronic device 101. For example, the camera module 312 may be disposed on a printed circuit board (e.g., a printed circuit board 340 of FIG. 4).

According to an embodiment, the camera module 305 and/or a sensor module may be disposed so as to be in contact with an external environment through a transparent area from an internal space of the electronic device 101 to the front plate 302 of the display 301. In addition, a sensor module 304 may be disposed to perform its function without being visually exposed through the front plate 302 in the internal space of the electronic device.

FIG. 4 is an exploded perspective view of an electronic device according to various embodiments.

Referring to FIG. 4, an electronic device 101 (e.g., the electronic device 101 of FIGS. 1 to 3) according to various embodiments may include a side bezel structure 331 (e.g., the side bezel structure 318 of FIG. 2), a first support member (e.g., support) 332, a front plate 320 (e.g., the front plate 302 of FIG. 2), a display 330 (e.g., the display 301 of FIG. 2), a printed circuit board 340 (e.g., a PCB, a flexible PCB (FPCB), or a rigid flexible PCB (RFPCB)), a battery 350 (e.g., the battery 189 of FIG. 1), a second support member 360 (e.g., a rear case), an antenna 370 (e.g., the antenna module 197 of FIG. 1), and a rear plate 380 (e.g., the rear plate 311 of FIG. 2). In some embodiments, at least one (e.g., the first support member 332 or the second support member 360) of the components may be omitted from the electronic device 101, or the electronic device 101 may additionally include other components. At least one of the components of the electronic device 101 may be the same as or similar to at least one of the components of the electronic device 101 of FIG. 2 or 3, and a redundant description thereof is omitted below.

According to various embodiments, the first support member 332 may be disposed inside the electronic device 101 to be connected to the side bezel structure 331 or to be configured integrally with the side bezel structure 331. The first support member 332 may be formed of, for example, a metal material and/or a non-metal (e.g., polymer) material. The first support member 332 may have one surface to which the display 330 is coupled, and the other surface to which the printed circuit board 340 is coupled.

According to various embodiments, a processor, a memory, and/or an interface may be mounted on the printed circuit board 340. The processor may include, for example, one or more of a central processing unit, an application processor, a graphic processing unit, an image signal processor, a sensor hub processor, or a communication processor. According to various embodiments, the printed circuit board 340 may include a flexible printed circuit board type radio frequency cable (FRC). For example, the printed circuit board 340 may be disposed in at least a part of the first support member 332, and may be electrically connected to an antenna module (e.g., the antenna module 197 of FIG. 1) and a communication module (e.g., the communication module 190 of FIG. 1).

According to an embodiment, the memory may include, for example, a volatile memory or a nonvolatile memory.

According to an embodiment, the interface may include, for example, a high definition multimedia interface (HDMI), a universal serial bus (USB) interface, an SD card interface, and/or an audio interface. For example, the interface may electrically or physically connect the electronic device 101 to an external electronic device, and include a USB connector, an SD card/MMC connector, or an audio connector.

According to various embodiments, the battery 350 is a device for supplying power to at least one component of the electronic device 101 and may include, for example, a non-rechargeable primary cell, a rechargeable secondary cell, or a fuel cell. For example, at least a part of the battery 350 may be disposed substantially on the same plane as the printed circuit board 340. The battery 350 may be integrally disposed inside the electronic device 101 or may be disposed detachably from the electronic device 101.

According to various embodiments, the second support member 360 (e.g., a rear case) may be disposed between the printed circuit board 340 and the antenna 370. For example, the second support member 360 may include one surface to which at least one of the printed circuit board 340 or the battery 350 is coupled, and the other surface to which the antenna 370 is coupled.

According to various embodiments, the antenna 370 may be disposed between the rear plate 380 and the battery 350. The antenna 370 may include, for example, a near field communication (NFC) antenna, a wireless charging antenna, and/or a magnetic secure transmission (MST) antenna. For example, the antenna 370 may perform short-range communication with an external device or wirelessly transmit/receive power required for charging. In an embodiment, an antenna structure may be configured by a part of the side bezel structure 331 and/or the first support member 332 or a combination thereof.

According to various embodiments, the rear plate 380 may configure at least a part of the rear surface (e.g., the second surface 310B of FIG. 3) of the electronic device 101.

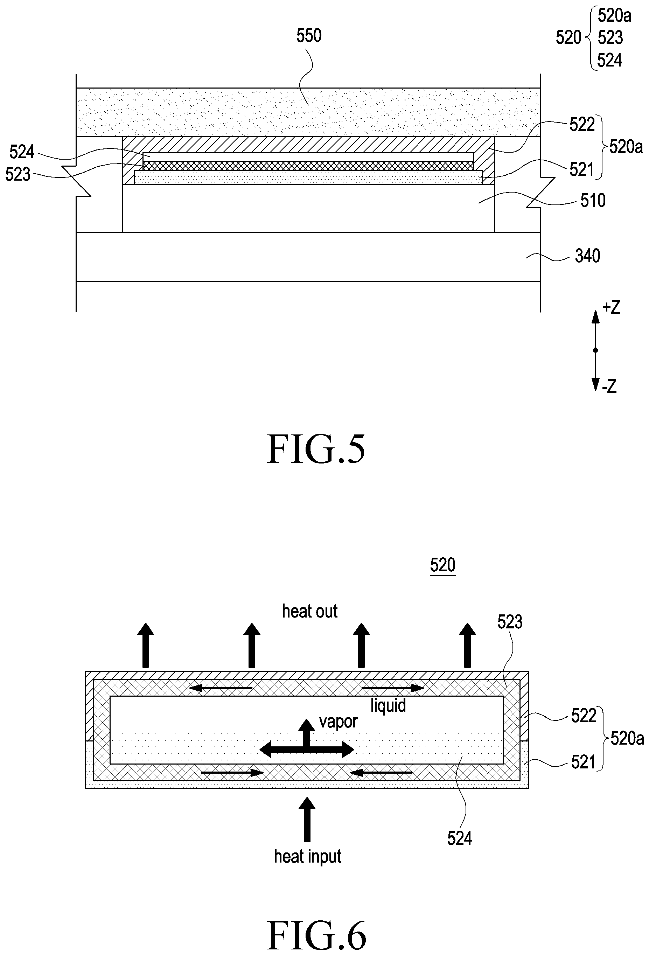

FIG. 5 is a cross-sectional view illustrating an example heat diffusion structure disposed in an electronic device and a structure around the heat diffusion structure according to various embodiments. FIG. 6 is a cross-sectional view illustrating a heat diffusion structure and function according to various embodiments.

According to various embodiments, an electronic device (e.g., the electronic device 101 of FIGS. 1 to 4) may include a circuit board 340, an electrical element 510 disposed on the circuit board 340, a heat diffusion structure 520 disposed in contact with the electrical element 510, and a bracket 550 disposed adjacent to the heat diffusion structure 520.

The structures of the circuit board 340 and the bracket 550 of the electronic device 101 shown in FIGS. 5 and 6 may be the same in whole or in part as those of the printed circuit board 340 and the first support member 332 of the electronic device 101 of FIG. 4.

In FIGS. 5 and 6, when the heat diffusion structure 520 is viewed from the side, "+Z or -Z" may indicate an upper and a lower direction. In addition, in an embodiment of the disclosure, "+Z" may denote a front direction in which the electrical element 510 disposed inside the electronic device faces a front cover (e.g., the front plate 320 of FIG. 4), and "-Z" may denote a rear direction in which the electrical device 510 disposed inside the electronic device faces a rear cover (e.g., the rear plate 380 of FIG. 4).

According to various embodiments, a plurality of electrical elements may be arranged on at least one side surface of the circuit board 340. The electrical element 510 among the plurality of electric elements is a heat source which generates heat, and may be, for example, at least one chip disposed on at least one side surface of the circuit board 340 and may include at least one of a power management integrated circuit (PMIC), a power amplifier (PAM), an application processor (AP), a communication processor (CP), a charge integrated circuit (charger IC), and a DC converter. In the embodiment of the disclosure, the electrical element 510 may be an application processor (AP) or a power management integrated circuit (PMIC).

According to various embodiments, the heat diffusion structure 520 may be disposed adjacent to the electrical element 510 and may diffuse heat generated from the electrical element 510. According to an embodiment, one surface of the heat diffusion structure 520 is disposed in contact with the electrical element 510, so that heat generated from the electrical element 510 can be efficiently transferred therein and diffused to the outside. For example, the heat diffusion structure 520 may include a water-cooling type heat diffusion member such as a heat pipe or a vapor chamber. In the heat diffusion structure 520 such as a heat pipe or a vapor chamber, a small amount of a working fluid in a sealed container is injected and vacuum-treated, so that heat can be efficiently transferred through a continuous phase change in which the fluid evaporates at the time of heat absorption and condenses at the time of heat release. The heat diffusion structure 520 may be disposed in contact with the bracket 550 to directly diffuse heat to the bracket 550.

According to various embodiments, the electronic device may further include a heat transfer member (not illustrated) disposed between the electrical element 510 and the heat diffusion structure 520 to transfer heat generated in the electric element 510 to the heat diffusion structure 520. For example, the heat transfer member may be formed of a carbon fiber thermal interface material (TIM) capable of transferring heat generated in the electrical element 510. For another example, the carbon fiber TIM (carbon fiber TIM) may include at least one of a liquid phase thermal interface material (TIM) and/or a solid phase thermal interface material (TIM). However, the heat transfer member is not limited to the carbon fiber TIM, and may include various heat dissipation materials or members for transferring heat generated in the electrical element 510 to the outside or a cover of the electronic device.

According to an embodiment, the heat diffusion structure 520 may include a housing 520a, a wick structure (e.g., wick) 523 disposed in the housing 520a, and a vapor passage 524. The housing 520a may be formed of a dissimilar metal member. For example, the housing 520a may include a first metal portion 521 and a second metal portion 522. The first metal portion 521 may be formed of a first material, the second metal portion 522 may be formed of a second material different from the first material, and at least a part of the second metal portion may be disposed to be bonded to the first metal portion 521. The first material may be a material having a higher reflectance and a higher thermal conductivity and thermal expansion rate compared to the second material.

For another example, the first material may be a copper alloy, and the copper alloy may include an oxygen-free copper (OFC) and/or an oxygen-free high thermal conductivity (OFHC) alloy. The copper alloy may include very low levels of oxygen and other chemical elements, and may have a copper purity of approximately 99.95% or higher. The second material may be a stainless alloy, and the stainless alloy may include 304, 304L and/or 316L. As the stainless alloy used as the second material, 316L having a relatively low carbon content may be used rather than 316 which is difficult to weld a dissimilar metal due to a high carbon content, or 304 having strong magnetic properties.

According to an embodiment, the wick structure 523 may be disposed in an internal space formed by the first metal portion 521 and the second metal portion 522 and may include a hygroscopic layer. For example, the wick structure 523 may include a copper mesh capable of storing a liquid such as pure water, ethanol, methanol, or acetone, and/or metal powder sintering. For another example, the wick structure 523 may be disposed adjacent to the first metal portion 521 or disposed adjacent to the second metal portion 522. For another example, the wick structure 523 may be designed to be positioned at an edge area of the internal space such that the vapor passage 524 is configured along the edge of the wick structure.

According to an embodiment, the vapor passage 524 may be disposed in contact with the wick structure 523 within the internal space formed by the first metal portion 521 and the second metal portion 522. The vapor passage 524 and the wick structure 523 may be variously designed and changed in order to diffuse heat within the internal space. For example, as illustrated in FIG. 5, the vapor passage 524 represents a space other than a space in which the wick structure 523 is disposed within the internal space, and in a case where the wick structure 523 is disposed in a lower part of the internal space, the vapor passage 524 may be disposed in an upper part of the internal space. For example, the vapor passage 524 may be configured as a remaining space excluding the wick structure 523 among the internal space. For another example, as illustrated in FIG. 6, the vapor passage 524 may be positioned at the center of the internal space of the housing 520a, and the wick structure 523 may be disposed to surround the periphery of the vapor passage 524 to provide a design for an easy heat exchange structure.

Hereinafter, various example embodiments of the housing 520a of the heat diffusion structure 520 made of a dissimilar metal are described in greater detail with reference to the figures.

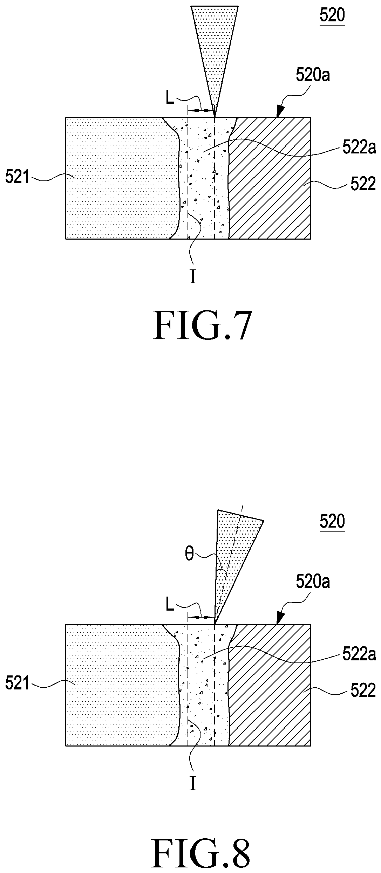

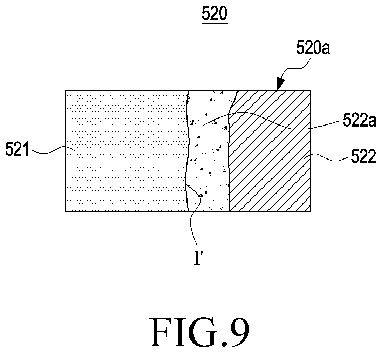

FIG. 7 is a diagram illustrating an outer surface of a housing of a heat diffusion structure according to various embodiments. FIG. 8 is a diagram illustrating an outer surface of a housing of a heat diffusion structure according to various embodiments. FIG. 9 is a cross-sectional view illustrating an inside of a housing of a heat diffusion structure, according to various embodiments.

According to various embodiments, an electronic device (e.g., the electronic device 101 of FIGS. 1 to 4) may include a circuit board (e.g., the circuit board 340 of FIG. 5), an electrical element (e.g., the electrical element 510 of FIG. 5) disposed on the circuit board 340, and a heat diffusion structure 520 disposed in contact with the electrical element 510.

A partial configuration of the heat diffusion structure 520 of the electronic device illustrated in FIGS. 7, 8 and 9 may be the same in whole or in part as the heat diffusion structure 520 of the electronic device of FIGS. 5 and 6.

According to various embodiments, the housing 520a of the heat diffusion structure 520 may include a first metal portion 521 and a second metal portion 522. The first metal portion 521 may be formed of a first material, the second metal portion 522 may be formed of a second material different from the first material, and at least a part of the second metal portion may be disposed to be bonded to the first metal portion 521. The first material may be a material having a higher reflectance and a higher thermal conductivity and thermal expansion rate compared to the second material.

According to various embodiments, the bonding of the first metal portion 521 and the second metal portion 522 may be formed using a laser. As the laser used for the bonding, a fiber, CO₂ and/or Nd:YAG laser may be used. The laser used for bonding according to various embodiments of the disclosure does not require laser vibration and wobbling through a galvoscan mirror head or a disk laser of green wavelength, generally used for metal bonding, and thus costs for equipment and bonding generation can be reduced, and space and time can be saved since a vacuum environment is not required.

According to various embodiments, a butt joint structure may be applied to the bonding of the first metal portion 521 and the second metal portion 522. For example, in a state in which a flat cross-section of the first metal portion 521 and a flat cross-section of the second metal portion 522 face and are in contact with each other, welding may be performed adjacent to an interface using a laser.

According to various embodiments, when viewed from the outside of the housing 520a (e.g., when looking at a bonding area of the first metal portion 521 and the second metal portion 522 from the outside) (for example, referring to FIG. 7 or 8), a welded portion (e.g., a bead) 522a of the second metal portion 522, the welded portion being disposed at an interface between the first metal portion 521 and the second metal portion 522, may be formed to surround at least a part of the first metal portion 521. According to an embodiment, when viewed from an inner cross-section of the housing 520a (e.g., when viewed from the inside of the bonding area of the first metal portion 521 and the second metal portion 522) (for example, referring to FIG. 9), the first metal portion 521 and the welded portion 522a of the second metal portion 522 formed at the interface of the second metal portion 522 may be disposed to face and to be in contact with each other. For example, on the outer surface of the housing 520a, the welded portion 522a of the second metal portion 522 may be disposed to cover up to a partial area of the first metal portion 521 beyond an interface I. However, inside the housing 520a, the welded portion 522a of the second metal portion 522 cannot penetrate the first metal portion 521 beyond an internal interface I', and thus may be formed only up to the internal interface I' area.

According to various embodiments, a method of manufacturing a housing 520a of a heat diffusion structure 520 may be performed through processes of forming a first metal portion 521 and a second metal portion 522 into a butt joint structure, and emitting a laser adjacently to an interface I of the first metal portion 521 and the second metal portion 522.

According to an embodiment, after the first metal portion 521 and the second metal portion 522 are brought into contact with each other, a position irradiated by a laser may be a part spaced apart by a specified distance toward the second metal portion 522 with reference to the interface I. As the position irradiated by the laser is offset to the interface I such that the same is directed to the second metal portion 522, areas in which heat is applied to the first metal portion 521 and the second metal portion 522 may be different, and accordingly, the bonding strength and surface flatness can be improved by controlling a relative composition ratio of the main components of a molten portion.

In general, when dissimilar metals of different materials are bonded to each other, if a laser is emitted toward an interface of dissimilar metals facing each other, due to the properties of different metals, microcracks may occur due to liquid separation and/or intermetallic compound formation in a fusion area inside the metals. For example, a metal having a relatively high reflectance (hereinafter, a copper alloy (e.g., corresponding to the first metal portion 521 of the disclosure)) reflects a significant part of the energy of a laser, and the energy of a laser reaching a metal having a relatively low reflectance (hereinafter, a stainless alloy (e.g., corresponding to the second metal portion 522 of the disclosure)) may reach a threshold value.

In an irradiation process of a laser, the penetration of laser energy is relatively strong in a stainless alloy, and accordingly, the quality of a welded portion may be deteriorated. In addition, as a keyhole is generated in a welded portion of the stainless alloy, high laser energy is absorbed into the keyhole, and an interface of a copper alloy having high reflectance around the keyhole may be melted.

After the laser irradiation is completed, due to rapid cooling and a rate of heat removal after welding, melting and cooling may occur and thus the heat of fusion release rate is exceeded. Accordingly, above a melting point, Fe of the stainless alloy and Cu of the copper alloy have high mutual solubility, but if a supercooling level reaches a miscibility gap, due to the strong convection caused by a laser in a melt pool, Fe and Cu may be separated into Fe and Cu liquids in all areas from a fusion zone to a fusion line. In the separated stainless alloy and copper liquids, depending on the ratio, one may be in a solidified state in a spherical form and the other one may be in a solidified state in a matrix form, and microcracks may be caused by bonding of dissimilar metals.

The heat diffusion structure 520 according to various embodiments of the disclosure may be implemented by offsetting a position irradiated by a laser by a specified distance toward the second metal portion 522 with reference to the interface I. By making areas where heat is applied to the first metal portion 521 and the second metal portion 522 different, a laser is emitted only to the second metal portion 522, a keyhole is formed on a side surface (edge surface) of the second metal portion 522, and a molten pool of the second metal portion 522 in a liquid state may interact with the first metal portion 521 in an unmelted solid state. Accordingly, the coupling between the first metal portion 521 and the second metal portion 522 may be stably induced. For example, since the first metal portion 521 does not melt, the second metal portion 522 in a liquid state may be in contact with the first metal portion 521 in a solid state, and heat may be rapidly dissipated and solidified to form a rough surface. Accordingly, the second metal portion 522 in the liquid state provides a strong force to the interface of the first metal portion 521 and, although the first metal portion 521 does not reach a melting point, recrystallization may occur due to an increase in temperature and grain growth may be caused.

According to an embodiment, the laser size (diameter) provided to the second metal portion 522 may be approximately 40 to 60 um. For example, in a case where the laser size (diameter) provided to the second metal portion 522 is configured to be approximately 50 um, a distance L spaced apart from the interface I may be configured within approximately 10 to 15% (~ 30 um) in proportion to the laser size and the thickness of the second metal portion 522. Accordingly, as the diameter of a laser deviates from the central part of the contacted surface (e.g., the interface I) and is positioned not too far away from the first metal portion 521, a keyhole (which provides recrystallizable heat to the first metal portion 521) for the first metal portion 521 may be generated around the interface.

According to an embodiment (referring to FIG. 7), an irradiation angle of a laser provided to the second metal portion 522 may be configured perpendicular to the outer surface of the second metal portion 522. According to an embodiment (referring to FIG. 8), an irradiation angle θ of a laser provided to the second metal portion 522 may be configured to be tilted by a specified angle toward the second metal portion 522 with reference to an upper direction (e.g., an outer surface direction) of the second metal portion 522. For example, an irradiation angle of a laser may be configured to be tilted by approximately 5 degrees or less with reference to a vertical direction of the outer surface of the second metal portion 522. Accordingly, while minimizing and/or reducing energy transfer through laser energy to the first metal portion 521, sufficient laser energy may be provided to the second metal portion 522. The melting of a partial area (e.g., an outer surface) of the first metal portion 521 can be prevented and/or alleviated, and the partial area may recrystallize without melting according to heat transfer due to the second metal portion 522, so that a strong coupling with the second metal portion 522 can be generated.

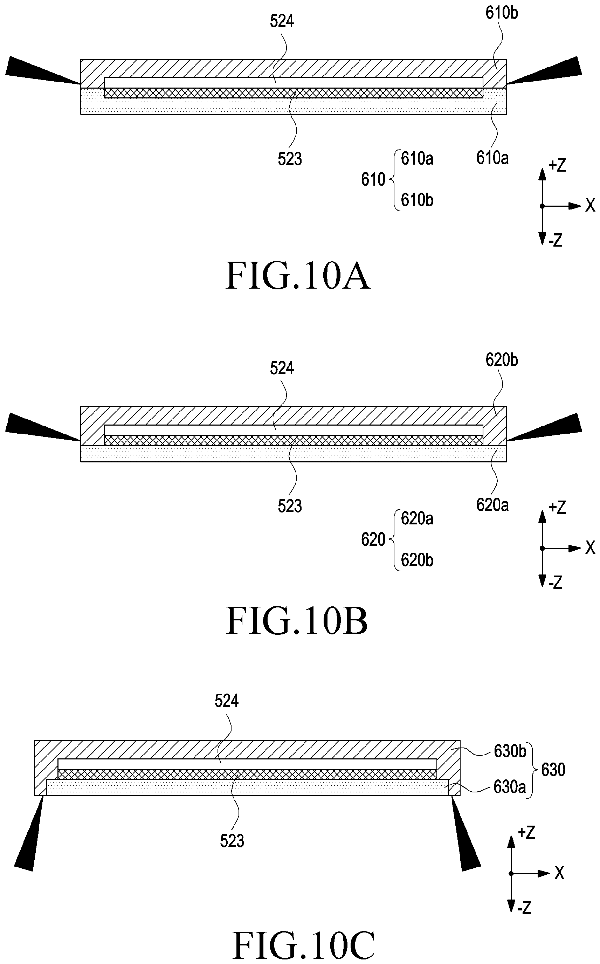

FIG. 10A is a cross-sectional view illustrating a heat diffusion structure made of a dissimilar metal and a position irradiated by a laser according to various embodiments. FIG. 10B is a cross-sectional view illustrating a heat diffusion structure made of a dissimilar metal and a position irradiated by a laser according to various embodiments. FIG. 10C is a cross-sectional view illustrating a heat diffusion structure made of a dissimilar metal and a position irradiated by a laser according to various embodiments.

According to various embodiments, an electronic device (e.g., the electronic device 101 of FIGS. 1 to 4) may include a circuit board (e.g., the circuit board 340 of FIG. 5), an electrical element (e.g., the electrical element 510 of FIG. 5) disposed on the circuit board 340, and a heat diffusion structure 610, 620, or 630 disposed in contact with the electrical element 510.

The heat diffusion structures 610, 620, and 630 of the electronic device illustrated in FIGS. 10A, 10B and 10C may be the same in whole or in part as the heat diffusion structure 520 of FIGS. 5, 6, 7, 8 and 9.

According to an embodiment, each of the heat diffusion structures 610, 620, and 630 may include a housing, a wick structure 523 disposed in the housing, and a vapor passage 524. The housing may be formed of a dissimilar metal member. For example, the housing may include a first metal portion 610a, 620a, or 630a and a second metal portion 610b, 620b, or 630b.

According to various embodiments, the first metal portions 610a, 620a, and 630a may be formed of a first material, the second metal portions 610b, 620b, and 630b may be formed of a second material different from the first material, and at least parts of the second metal portions 610b, 620b, and 630b may be disposed to be bonded to the first metal portions 610a, 620a, and 630a. The first material may be a material having a higher reflectance and a higher thermal conductivity and thermal expansion rate compared to the second material. For example, the first metal portions 610a, 620a, and 630a may be a copper alloy, and the second metal portions 610a, 620a, and 630a may be a stainless alloy.

According to various embodiments, the thickness of each of the heat diffusion structures 610, 620, and 630 may be approximately 0.25 to 0.35 mm as a whole. For example, the thickness of each of the heat diffusion structures 610, 620, and 630 may be approximately 0.3 mm. The heat diffusion structures 610, 620, and 630 according to various embodiments of the disclosure have a thickness smaller than the thickness (e.g., 0.35 mm or less using a copper alloy) of the heat diffusion structure made of a single material, and use a stainless alloy having high rigidity in addition to a copper alloy, so that rigidity and heat dissipation can be secured while reducing the overall thickness.

According to various embodiments, the heat diffusion structures 610, 620, and 630 may be dissimilar metal bonding structures, and a stainless alloy and a copper alloy may have a butt joint structure applied thereto. The thickness of the stainless alloy may be designed to be smaller than the thickness of the copper alloy. For example, the thickness of the stainless alloy may be approximately 45 to 55 um, and the thickness of the copper alloy may be approximately 90 to 110 um. The thickness of the vapor passage 524 may be approximately 100 um, and the thickness of the wick structure 523 may be approximately 50 um. For another example, the thickness of the stainless alloy may be approximately 50 um, and the thickness of the copper alloy may be approximately 100 um. The thickness of the vapor passage 524 may be approximately 100 um, and the thickness of the wick structure 523 may be approximately 50 um. However, the configuration of the thickness is merely an example and is not limited thereto, and the sizes (e.g., thicknesses) of the heat diffusion structures 610, 620, and 630 may be designed and changed to be smaller according to the size of the electronic device.

Referring to FIG. 10A, the housing may be surrounded by the first metal portion 610a and the second metal portion 610b to form an internal space. The second metal portion 620b may include a front portion which faces a first direction +Z and at least a part of which has a plate shape, and a side portion which extends from the front portion and faces a second direction X perpendicular to the first direction +Z. For example, the second metal portion 620b may have a " 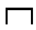 " shape. The first metal portion 610a may be manufactured to have a shape corresponding to the second metal portion 610b. The first metal portion 610a may include a rear portion which faces a third direction -Z opposite to the first direction +Z and at least a part of which has a plate shape, and a side portion which extends from the rear portion and faces the second direction X perpendicular to the third direction. For example, the first metal portion 610a may have a " 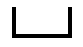 " shape.

According to various embodiments, an area irradiated by a laser may be an area spaced apart by a specified distance toward the second metal portion 610b at a bonding portion (e.g., an interface) of the first metal portion 610a and the second metal portion 610b. For example, an irradiation angle of a laser may be configured to be tilted by approximately 0 degrees or greater and 5 degrees or less with reference to a vertical direction of the outer surface of the second metal portion 610b. At the time of welding the bonding portion of the first metal portion 610a and the second metal portion 610b, the second metal portion 610b is melted, and the second metal portion in a liquid state may serve as a keyhole wall of the first metal portion 610a which has high temperature and is not melted during welding. Accordingly, it is possible to provide a metallurgical bonding by element diffusion between the first metal portion 610a and the second metal portion 610b in a high temperature and high pressure environment, and to prevent and/or reduce strength decrease. As a laser emitted to the second metal portion 610b, a CO₂, Nd:YAG, and fiber laser may be used. The wavelength regions of the Nd:YAG and fiber lasers may include approximately 473 to 1090 nm. When using the CO₂ laser, the wavelength region may be around approximately 10 um, such as 1090 nm or greater (e.g., approximately 10 times the wavelength regions of the Nd:YAG and fiber lasers). A laser welding speed may be configured between 1 to 5000 mm/s and the power may be configured between 10 to 500 W, and may be adjusted according to a material, thickness, or size of the first metal portion 610a and the second metal portion 610b, a beam size, or the like.

Referring to FIG. 10B, the housing may be surrounded by the first metal portion 620a and the second metal portion 620b to form an internal space. The second metal portion 620b may include a front portion which faces a first direction +Z and at least a part of which has a plate shape, and a side portion which extends from the front portion and faces a second direction X perpendicular to the first direction +Z. For example, the second metal portion 620b may have a " 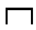 " shape. The first metal portion 620a may be manufactured to have a shape corresponding to the second metal portion 620b. The first metal portion 620a may include a rear portion which faces a third direction -Z opposite to the first direction +Z. The rear portion may have a plate shape as a whole. According to an embodiment, an area irradiated by a laser may be an area spaced apart by a specified distance toward the second metal portion 620b at a bonding portion (e.g., an interface) of the first metal portion 620a and the second metal portion 620b. An irradiation angle of a laser may be configured to be tilted by approximately 5 degrees or less with reference to a vertical direction of the outer surface of the second metal portion 620b.

Referring to FIG. 10C, the housing may be surrounded by the first metal portion 630a and the second metal portion 630b to form an internal space. The second metal portion 630b may include a front portion which faces a first direction +Z and at least a part of which has a plate shape, and a side portion which extends from the front portion and faces a second direction X perpendicular to the first direction +Z. For example, the second metal portion 630b may have a " 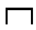 " shape. An end of the side portion of the second metal portion 630b may have a stepped shape, and a partial area thereof may face a rear surface facing a third direction -Z opposite to the first direction +Z. The first metal portion 630a may include a rear portion which faces the third direction -Z opposite to the first direction +Z. An end of the first metal portion 630a may have a stepped shape to correspond to the end of the second metal portion 630b. According to various embodiments, an area irradiated by a laser may be an area spaced apart by a specified distance toward the second metal portion 630b at a bonding portion (e.g., an interface) of the first metal portion 630a and the second metal portion 630b. For example, an irradiation angle of a laser may be configured to be tilted by approximately 5 degrees or less with reference to a vertical direction of the outer surface of the second metal portion 630b.

As shown in FIGS. 10A, 10B and 10C, the first metal portions 610a, 620a, and 630a are shown as lower plates, the second metal portions 610b, 620b, and 630b are shown as upper plates, but are not limited thereto, and the first metal portions 610a, 610b, and 630a may be designed and changed as upper plates and the second metal portions 610b, 620b, and 630b may be designed and changed as lower plates.

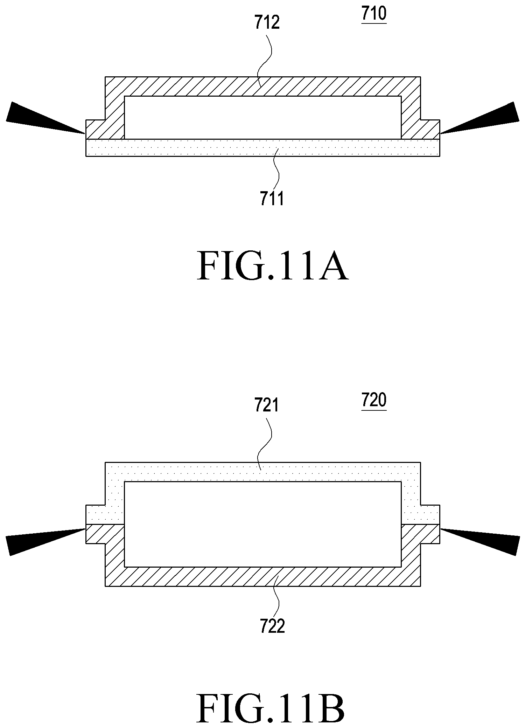

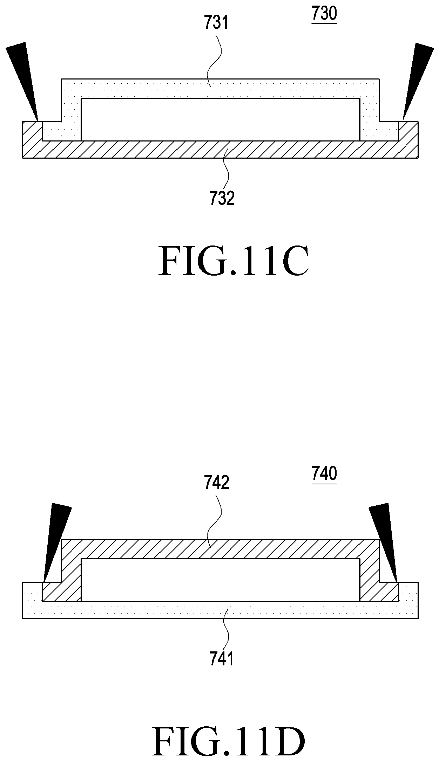

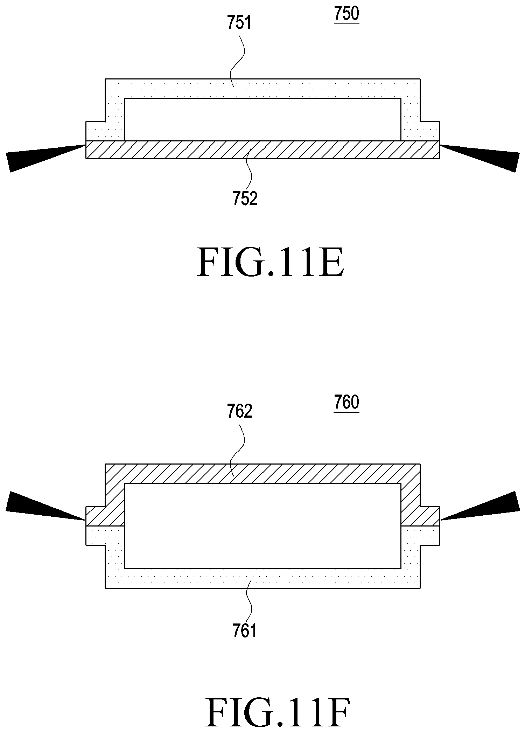

FIGS. 11A, 11B, 11C, 11D, 11E and 11F are schematic cross-sectional views illustrating a heat diffusion structure made of a dissimilar metal and a position irradiated by a laser according to various embodiments.

According to various embodiments, an electronic device (e.g., the electronic device 101 of FIGS. 1 to 4) may include a circuit board (e.g., the circuit board 340 of FIG. 5), an electrical element (e.g., the electrical element 510 of FIG. 5) disposed on the circuit board 340, and a heat diffusion structure 710, 720, 730, 740, 750, or 760 disposed in contact with the electrical element 510.

The heat diffusion structure 520 of the electronic device illustrated in FIGS. 11A, 11B, 11C, 11D, 11E and 11F may be the same in whole or in part as the heat diffusion structure 520 of FIGS. 10A, 10B and 10C.

According to various embodiments, each of the heat diffusion structures 710, 720, 730, 740, 750, and 760 may include a housing having a dissimilar metal structure, and the housing may include a first metal portion 711, 721, 731, 741, 751, or 761 and a second metal portion 712, 722, 732, 742, 752, or 762. For example, the first metal portions 711, 721, 731, 741, 751, and 761 may be a copper alloy, and the second metal portions 712, 722, 732, 742, 752, and 762 may be a stainless alloy.

According to various embodiments, the thickness of each of the heat diffusion structures 710, 720, 730, 740, 750, and 760 may be approximately 0.25 to 0.35 mm as a whole. For example, the thickness of each of the heat diffusion structures 710, 720, 730, 740, 750, and 760 may be approximately 0.3 mm. The heat diffusion structures 710, 720, 730, 740, 750, and 760 according to various embodiments of the disclosure have a thickness smaller than the thickness (e.g., 0.35 mm or less using a copper alloy) of the heat diffusion structure made of a single material, and use a stainless alloy having high rigidity in addition to a copper alloy, so that rigidity and heat dissipation can be secured while reducing the overall thickness.

According to various embodiments, an area irradiated by a laser may be an area spaced apart by a specified distance toward the second metal portion 712, 722, 732, 742, 752, or 762 at a bonding portion (e.g., an interface) of the first metal portion 711, 721, 731, 741, 751, or 761 and the second metal portion 712, 722, 732, 742, 752, or 762. An irradiation angle of a laser may be configured to be tilted by approximately 5 degrees or less with reference to a vertical direction of the outer surface of the second metal portion 712, 722, 732, 742, 752, or 762.

Referring to FIG. 11A, the housing may be surrounded by the first metal portion 711 and the second metal portion 712 to form an internal space. The first metal portion 711 may configure a lower plate, and the second metal portion 712 may configure an upper plate. The first metal portion 711 may be manufactured to have a plate shape as a whole, and both ends of the second metal portion 712 may be manufactured to have a stepped shape to form a butt joint structure with both ends of the first metal portion 711. For example, the both ends of the second metal portion 712 may have a "┘" or "└" shape. An area irradiated by a laser may be a part of a side surface of the housing in which a bonding portion (e.g., an interface) of the first metal portion 711 and the second metal portion 712 is positioned.

Referring to FIG. 11B, the housing may be surrounded by the first metal portion 721 and the second metal portion 722 to form an internal space. The first metal portion 721 may configure an upper plate, and the second metal portion 722 may configure a lower plate. Both ends of the first metal portion 721 and the second metal portion 722 may be manufactured to have a shape protruding outward to be advantageous for bonding. An area irradiated by a laser may be a part of a side surface of the housing in which a bonding portion (e.g., an interface) of the first metal portion 721 and the second metal portion 722 is positioned.

Referring to FIG. 11C, the housing may be surrounded by the first metal portion 731 and the second metal portion 732 to form an internal space. The first metal portion 731 may configure an upper plate, and the second metal portion 732 may configure a lower plate. Both ends of the first metal portion 731 may be manufactured to have a shape protruding outward to be advantageous for bonding. Both ends of the second metal portion 732 may be manufactured to be advantageous in bonding, to overall support the first metal portion 731, and to surround at least a part of the both ends of the first metal portion 731. An area irradiated by a laser may be a part facing an upper side of the housing in which a bonding portion (e.g., an interface) of the first metal portion 731 and the second metal portion 732 is positioned.

Referring to FIG. 11D, the housing may be surrounded by the first metal portion 741 and the second metal portion 742 to form an internal space. The positions of the first metal portion 741 and the second metal portion 742 of FIG. 11D may be opposite to those of FIG. 11C. An area irradiated by a laser may be a part facing an upper side of the housing in which a bonding portion (e.g., an interface) of the first metal portion 741 and the second metal portion 742 is positioned.

Referring to FIG. 11E, the housing may be surrounded by the first metal portion 751 and the second metal portion 752 to form an internal space. The positions of the first metal portion 751 and the second metal portion 752 of FIG. 11E may be opposite to those of FIG. 11A. An area irradiated by a laser may be a part of a side surface of the housing in which a bonding portion (e.g., an interface) of the first metal portion 751 and the second metal portion 752 is positioned.

Referring to FIG. 11F, the housing may be surrounded by the first metal portion 761 and the second metal portion 762 to form an internal space. The positions of the first metal portion 761 and the second metal portion 762 of FIG. 11F may be opposite to those of FIG. 11B. An area irradiated by a laser may be a part of a side surface of the housing in which a bonding portion (e.g., an interface) of the first metal portion 761 and the second metal portion 762 is positioned.

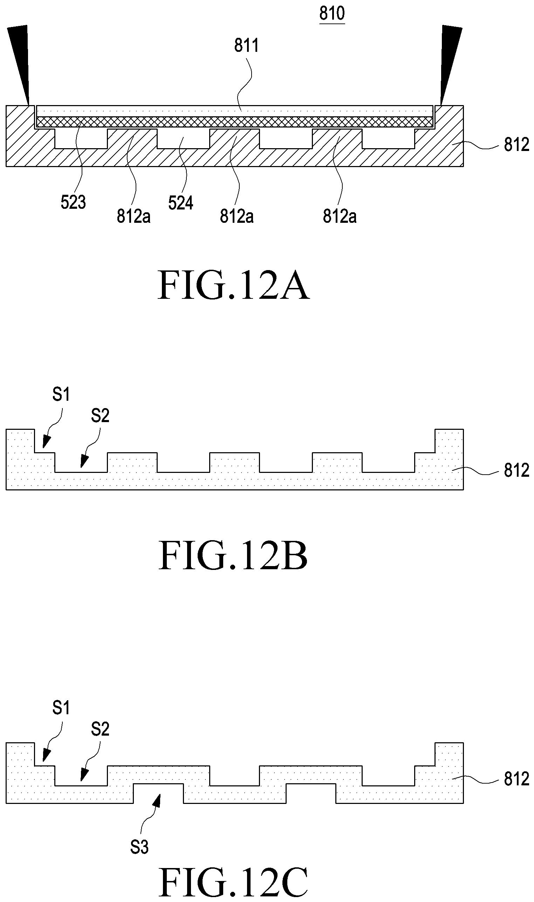

FIGS. 12A, 12B and 12C are schematic cross-sectional views illustrating a heat diffusion structure made of a dissimilar metal and a position irradiated by a laser according to various embodiments.

According to various embodiments, an electronic device (e.g., the electronic device 101 of FIGS. 1 to 4) may include a circuit board (e.g., the circuit board 340 of FIG. 5), an electrical element (e.g., the electrical element 510 of FIG. 5) disposed on the circuit board 340, and a heat diffusion structure 810 disposed in contact with the electrical element 510.

The heat diffusion structure 810 of the electronic device illustrated in FIGS. 12A, 12B and 12C may be the same in whole or in part as the heat diffusion structures 610, 620, and 630 of FIGS. 10A, 10B and 10C.

According to various embodiments, the heat diffusion structure 810 may include a housing, a wick structure 523 disposed in the housing, and a vapor passage 524. The housing may be formed of a dissimilar metal member. The housing may include a first metal portion 811 and a second metal portion 812. For example, the first metal portion 811 may be a copper alloy, and the second metal portion 812 may be a stainless alloy.

According to various embodiments, the first metal portion 811 may configure an upper plate, and the second metal portion 812 may configure a lower plate. The first metal portion 811 may be provided to have a plate shape, and the second metal portion 812 may include a plurality of partition walls 812a capable of supporting the first metal portion 811 to prevent and/or reduce deformation of an internal space. For example, since the vapor pressure inside the heat diffusion structure 810 is smaller than the atmospheric pressure at a temperature of less than 100 degrees, the plurality of partition walls 812a may be disposed on an inner wall of the second metal portion 812 to prevent and/or reduce an outer wall from being deformed inward. The plurality of partition walls 812a may be formed by etching processing or using etching processing and press processing, and a processed area may be used as a fluid passage.

For example, referring to FIG. 12B, a case in which the second metal portion 812 may be configured as a lower plate indicates that a first area S1 may be formed through a first etching processing facing a downward direction and a second area S2 may be formed through a second etching processing facing a downward direction. For another example, referring to FIG. 12C, a case in which the second metal portion 812 may be configured as a lower plate indicates that a first area S1 and a second area S2 may be formed through a first etching processing and a second etching processing facing a downward direction and a third area S3 may be formed through a press process facing an upward direction.

However, as shown in FIGS. 12A, 12B and 12C, in the housing structure, in addition to the first metal portion 811 configuring an upper plate and the second metal portion 812 configuring a lower plate, the first metal portion 811 may be easily designed to configure a lower plate and the second metal portion 812 may be easily designed to configure an upper plate. For example, a stainless alloy may be disposed in an upper part of a heat source, and a copper alloy may be produced to include a plurality of partition walls in order to prevent and/or reduce deformation of an internal space.

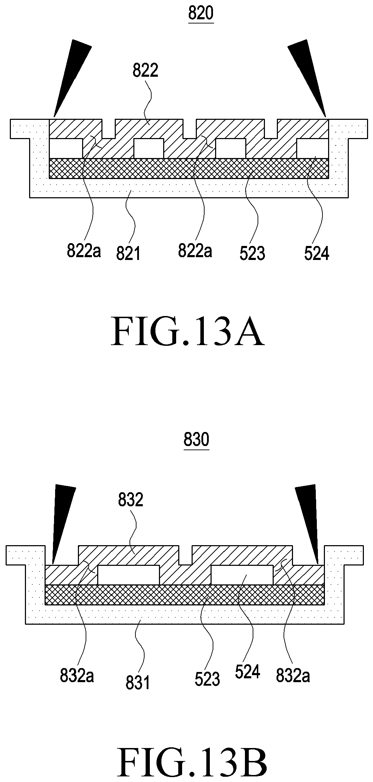

FIGS. 13A and 13B are cross-sectional views illustrating a heat diffusion structure made of a dissimilar metal and a position irradiated by a laser according to various embodiments.

According to various embodiments, an example electronic device (e.g., the electronic device 101 of FIGS. 1 to 4) may include: a circuit board (e.g., the circuit board 340 of FIG. 5), an electrical element (e.g., the electrical element 510 of FIG. 5) disposed on the circuit board 340, and a heat diffusion structure 820 or 830 disposed in contact with the electrical element 510.

The heat diffusion structures 820 and 830 of the electronic device illustrated in FIGS. 13A and 13B may be the same in whole or in part as the heat diffusion structure 810 of FIGS. 12A, 12B and 12C.

According to an embodiment, each of the heat diffusion structures 820 and 830 may include a housing, a wick structure 523 disposed in the housing, and a vapor passage 524. The housing may be formed of a dissimilar metal member. The housing may include a first metal portion 821 or 831 and a second metal portion 822 or 832. For example, the first metal portions 821 and 831 may be a copper alloy, and the second metal portions 822 and 832 may be a stainless alloy.

According to various embodiments, the first metal portions 821 and 831 may configure a lower plate, and the second metal portion 822 and 832 may configure an upper plate. The first metal portions 821 and 831 may be provided to have shapes which can receive the second metal portions 822 and 832, and the second metal portions 822 and 832 may include a plurality of partition walls 822a and 832a capable of supporting the first metal portions 821 and 831 to prevent and/or reduce deformation of an internal space. The plurality of partition walls 822a and 832a may be formed by etching processing or using etching processing and press processing, and a processed area may be used as a fluid passage. An area irradiated by a laser may be a part of an upper surface of the housing in which a bonding portion (e.g., an interface) of the first metal portion 821 or 831 and the second metal portion 822 or 832 is positioned.

However, in the housing, the arrangement of the first metal portions 821 and 831 and the second metal portions 822 and 832 is not limited to the illustrated embodiment, and the first metal portions 821 and 831 may configure an upper plate, and the second metal portion 822 and 832 may configure a lower plate. For example, a stainless alloy may be provided to have a shape which can receive a copper alloy, and the copper alloy may include a plurality of partition walls capable of supporting the stainless alloy in order to prevent and/or reduce deformation of an internal space.

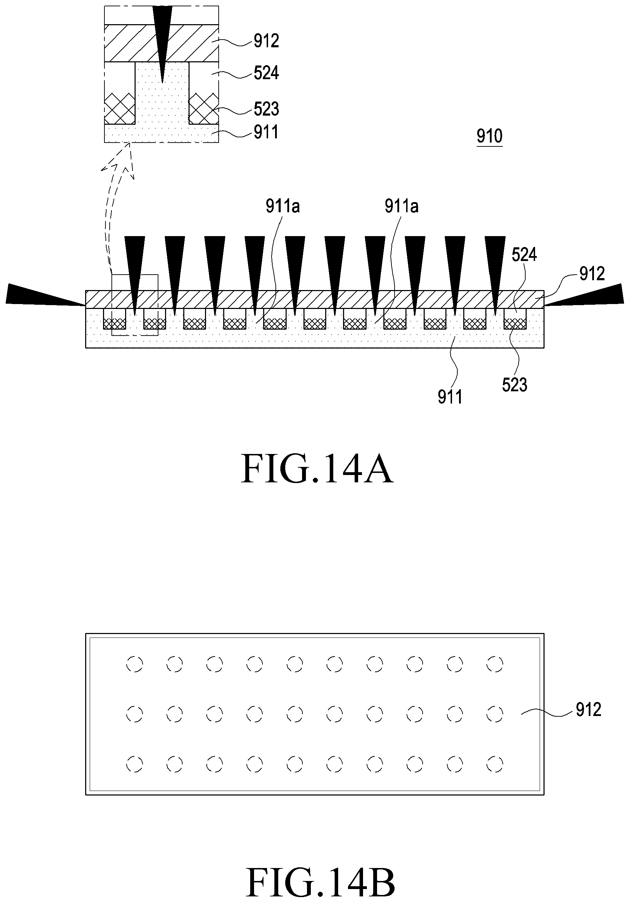

FIG. 14A is a cross-sectional view illustrating a heat diffusion structure made of a dissimilar metal and a position irradiated by a laser according to various embodiments. FIG. 14B is a projection view of FIG. 14A when viewed from the top according to various embodiments.

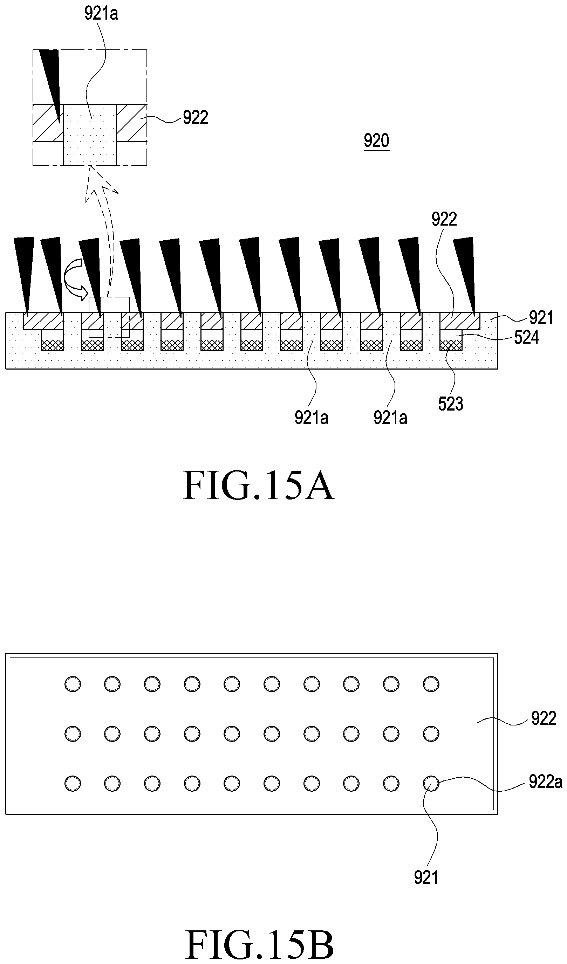

FIG. 15A is a cross-sectional view illustrating a heat diffusion structure made of a dissimilar metal and a position irradiated by a laser according to various embodiments. FIG. 15B is a view of FIG. 15A when viewed from the top according to various embodiments.

According to various embodiments, an electronic device (e.g., the electronic device 101 of FIGS. 1 to 4) may include a circuit board (e.g., the circuit board 340 of FIG. 5), an electrical element (e.g., the electrical element 510 of FIG. 5) disposed on the circuit board 340, and a heat diffusion structure 910 or 920 disposed in contact with the electrical element 510.

The heat diffusion structures 910 and 920 of the electronic device illustrated in FIGS. 14A, 14B, 15A and 15B may be the same in whole or in part as the heat diffusion structures 810, 820, and 830 of FIGS. 12A, 12B, 12C, 13A and 13B.

According to an embodiment, each of the heat diffusion structures 910 and 920 may include a housing, a wick structure 523 disposed in the housing, and a vapor passage 524. The housing may be formed of a dissimilar metal member. The housing may include a first metal portion 911 or 921 and a second metal portion 912 or 922. For example, the first metal portions 911 and 921 may be a copper alloy, and the second metal portions 912 and 922 may be a stainless alloy.

According to various embodiments, the first metal portions 911 and 921 may configure a lower plate (or upper plate), and the second metal portions 912 and 922 may configure an upper plate (or lower plate). According to an embodiment, the first metal portions 911 and 921 may include a plurality of partition walls 911a and 921a capable of supporting the second metal portions 912 and 922 to prevent and/or reduce deformation of the heat diffusion structures 910 and 920. The plurality of partition walls 911a and 921a may be formed by etching processing or using etching processing and press processing. An area irradiated by a laser may be a part of an upper surface of the housing in which a bonding portion (e.g., an interface) of the first metal portion 911 or 921 and the second metal portion 912 or 922 is positioned.

Referring to FIGS. 14A and 14B, the second metal portion 912 may be positioned as a plate-shaped upper plate, and the plurality of partition walls 911a of the first metal portion 911 may be positioned under the second metal portion 912 to support the second metal portion 912. A laser may be emitted to an area in which the first metal portion 911 and the second metal portion 912 are stacked. For example, in a case where one area of the second metal portion 912 and the partition walls of the first metal portion 911 face each other and are stacked, a laser may be emitted in the form of a spot toward the one area of the second metal portion 912 to weld the one area of the second metal portion 912 and the first metal portion 911.

Referring to FIGS. 15A and 15B, while the second metal portion 922 is positioned as a plate-shaped upper plate, the second metal portion may have a plurality of holes 922a through which the plurality of partition walls 921a of the first metal portion 911 can extend. The plurality of partition walls 921a may be fittedly coupled to the plurality of holes 922a, respectively. The plurality of holes 922a may be manufactured to have a shape corresponding to the shape (e.g., a cylinder, a triangular pillar, or a rectangular pillar) of the plurality of partition walls 921a. A laser may be emitted along the circumference of each of the plurality of holes 922a of the second metal portion 922. For example, when viewed from the top of the housing, the plurality of partition walls 921a of the first metal portion 921 are arranged in the plurality of holes 922a of the second metal portion 922, respectively, and a laser may be emitted in the form of a line rather than a spot to weld the first metal portion 921 and the second metal portion 922.

An electronic device (e.g., the electronic device 101 of FIGS. 1 to 4) according to various example embodiments may include: a housing (e.g., the housing 310 of FIGS. 2 and 3), a printed circuit board (e.g., the circuit board 340 of FIG. 5) disposed in the housing, an electrical element (e.g., the electrical element 510 of FIG. 5) disposed on the printed circuit board, and a dissimilar metal structure disposed adjacent to the electrical element. The dissimilar metal structure may include a first metal portion (e.g., the first metal portion 521 of FIG. 5) comprising a first material, a second metal portion (e.g., the second metal portion 522 of FIG. 5) comprising a second material different from the first material, wherein at least a part of the second metal portion is bonded to the first metal portion, a vapor passage (e.g., the vapor passage 524 of FIG. 5) disposed in a space surrounded by the first metal portion and the second metal portion, and a wick (e.g., the wick structure 523 of FIG. 5) disposed in contact with at least a part of the vapor passage in the space, and when viewed from above the dissimilar metal structure, a welded portion (e.g., the welded portion 522a of FIG. 8) of the second metal portion, the welded portion being disposed at an interface between the first metal portion and the second metal portion, may be disposed to surround at least a part of the first metal portion.

According to various example embodiments, the bonding of the first metal portion and the second metal portion may include a butt joint structure.

According to various example embodiments, the bonding of the first metal portion and the second metal portion may be formed by welding using a laser.

According to various example embodiments, a position irradiated by the laser for bonding of the first metal portion and the second metal portion may be an area spaced apart by a specified distance toward the second metal portion, with reference to the interface between the first metal portion and the second metal portion.

According to various example embodiments, a position irradiated by the laser for bonding of the first metal portion and the second metal portion may be spaced apart by a specified distance toward the second metal portion, with reference to the interface between the first metal portion and the second metal portion, and an irradiation angle of the laser for bonding of the first metal portion and the second metal portion may be tilted by a specified angle toward the second metal portion, with reference to an upper direction of the second metal portion.

According to various example embodiments, a spaced distance toward the second metal portion with reference to the interface may be in a range of about 10% to 15% or less with respect to the thickness of the second metal portion.

According to various example embodiments, the specified angle for the laser irradiation may be in a range of about 0 degrees to 5 degrees or less.

According to various example embodiments, the laser may include at least one of a CO₂, fiber, or Nd:YAG laser.

According to various example embodiments, by the laser, the second metal portion may be melted and thus undergo a phase change from a solid state to a liquid state, and the first metal portion may not undergo the phase change from the solid state to the liquid state.

According to various example embodiments, the first metal portion may include a material having a higher reflectance a reflectance of the second metal portion, and the first metal portion may include a copper alloy.

According to various example embodiments, the first metal portion may include a material having a higher reflectance than a reflectance of the second metal portion, and the second metal portion may include a stainless alloy.

According to various example embodiments, at an internal interface of the dissimilar metal structure, the welded portion of the second metal portion and the first metal portion may be disposed to face each other and to be in contact with each other.

According to various example embodiments, at least a partial area of the second metal portion may be provided in a plate shape, and the first metal portion may include a plurality of partition walls capable of supporting the at least a partial area of the second metal portion.

According to various example embodiments, the at least a partial area of the second metal portion may include a plurality of holes through which the plurality of partition walls of the first metal portion can extend.

An electronic device according to various example embodiments may include: a housing, a printed circuit board disposed in the housing, an electrical element disposed on the printed circuit board, and a dissimilar metal structure disposed adjacent to the electrical element. The dissimilar metal structure may include a first metal portion comprising a first material, a second metal portion comprising a second material different from the first material, wherein at least a part of the second metal portion is bonded to the first metal portion, a vapor passage disposed in a space surrounded by the first metal portion and the second metal portion, and a wick disposed in contact with at least a part of the vapor passage in the space, wherein when an interface of the first metal portion and the second metal portion is viewed from the inside of the dissimilar metal structure, a welded portion of the second metal portion and the first metal portion may be disposed to face and to be in contact with each other.

According to various example embodiments, a position irradiated by a laser for bonding of the first metal portion and the second metal portion may be spaced apart by a specified distance toward the second metal portion, with reference to the interface between the first metal portion and the second metal portion.

According to various example embodiments, when viewed from above the dissimilar metal structure, the welded portion of the second metal portion, the welded portion being disposed at an outer interface between the first metal portion and the second metal portion, may be disposed to surround at least a part of the first metal portion.

A method of manufacturing a dissimilar metal structure of an electronic device according to various embodiments may include: forming a first metal portion and a second metal portion into a butt joint structure, and emitting a laser adjacent to an interface between the first metal portion and the second metal portion, wherein a position irradiated by the laser for bonding of the first metal portion and the second metal portion is an area spaced apart by a specified distance toward the second metal portion, with reference to the interface between the first metal portion and the second metal portion.

According to various example embodiments, an irradiation angle of the laser for bonding of the first metal portion and the second metal portion may be tilted by a specified angle toward the second metal portion, with reference to an upper direction of the second metal portion.

According to various example embodiments, by the laser irradiation, the second metal portion may be melted and undergo a phase change from a solid state to a liquid state, and the first metal portion may not undergo the phase change from the solid state to the liquid state.

A heat diffusion structure and an electronic device including the same according to various example embodiments of the disclosure described above are not limited by the above-described embodiments and drawings, and it will be apparent to a person skilled in the art to which the disclosure pertains that various substitutions, modifications, and changes are possible within the technical scope of the disclosure, including the appended claims and their equivalents.

## Claims

1. An electronic device comprising:
a housing;
a printed circuit board disposed in the housing;
an electrical element disposed on the printed circuit board; and
a dissimilar metal structure disposed adjacent to the electrical element,
wherein the dissimilar metal structure comprises:
a first metal portion made of a first material;
a second metal portion made of a second material different from the first material, wherein at least a part of the second metal portion is bonded to the first metal portion;
a vapor passage disposed in a space surrounded by the first metal portion and the second metal portion; and
a wick disposed in contact with at least a part of the vapor passage in the space, and
wherein when viewed from above the dissimilar metal structure, a welded portion of the second metal portion, the welded portion being disposed at an interface between the first metal portion and the second metal portion, is disposed to surround at least a part of the first metal portion.

2. The electronic device of claim 1, wherein bonding of the first metal portion and the second metal portion includes a butt joint structure.

3. The electronic device of claim 1, wherein bonding of the first metal portion and the second metal portion comprises welding using a laser.

4. The electronic device of claim 3, wherein a position irradiated by the laser for bonding of the first metal portion and the second metal portion is spaced apart by a specified distance toward the second metal portion, with reference to the interface between the first metal portion and the second metal portion.

5. The electronic device of claim 3, wherein a position irradiated by the laser for bonding of the first metal portion and the second metal portion is spaced apart by a specified distance toward the second metal portion, with reference to the interface between the first metal portion and the second metal portion, and
an irradiation angle of the laser for bonding of the first metal portion and the second metal portion is tilted by a specified angle toward the second metal portion, with reference to an upper direction of the second metal portion.

6. The electronic device of claim 5, wherein a spaced distance toward the second metal portion with reference to the interface is configured to be 10% to 15% or less with respect to a thickness of the second metal portion.

7. The electronic device of claim 5, wherein the specified angle for the laser irradiation is 0 degrees to 5 degrees or less.

8. The electronic device of claim 7, wherein the laser comprises at least one of a CO₂, fiber, or Nd:YAG laser.

9. The electronic device of claim 7, wherein, by the laser, the second metal portion is melted and undergoes a phase change from a solid state to a liquid state, and the first metal portion does not undergo the phase change from the solid state to the liquid state.

10. The electronic device of claim 1, wherein the first metal portion comprises a material having a higher reflectance than a reflectance of the second metal portion, and the first metal portion comprises a copper alloy.

11. The electronic device of claim 1, wherein the first metal portion comprises a material having a higher reflectance than a reflectance of the second metal portion, and the second metal portion comprises a stainless alloy.

12. The electronic device of claim 1, wherein, at an internal interface of the dissimilar metal structure, the welded portion of the second metal portion and the first metal portion are disposed to face each other and to be in contact with each other.

13. The electronic device of claim 1, wherein at least a partial area of the second metal portion has a plate shape, and
the first metal portion comprises a plurality of partition walls capable of supporting the at least a partial area of the second metal portion.

14. The electronic device of claim 13, wherein the at least a partial area of the second metal portion comprises a plurality of holes through which the plurality of partition walls of the first metal portion can extend.
